# EUROPEAN PATENT APPLICATION

(11) **EP 1 291 920 A2**
(43) Date of publication of application: **12.03.2003**
(21) Application number: 02019113.6
(22) Date of filing: 29.08.2002
(51) Int. Cl.: H01L 27/142, H01L 31/18, H01L 21/027

(54) **Solar cell, method for manufacturing the same, and apparatus for manufacturing the same**

(30) Priority: 31.08.2001 JP 2001264397; 18.12.2001 JP 2001384788
(71) Applicant: MATSUSHITA ELECTRIC INDUSTRIAL CO., LTD., Kadoma-shi, Osaka 571-8501 (JP)
(72) Inventor: Shimakawa, Shinichi, Ikoma-shi, Nara 630-0133 (JP); Muro, Masahiro, Sakai-shi, Osaka 590-0134 (JP); Satoh, Takuya, Yamatokooriyama-shi, Nara 639-1124 (JP); Negami, Takayuki, Hirakata-shi, Osaka 573-0164 (JP)
(74) Representative: VOSSIUS & PARTNER

(57) **Abstract**

A method and an apparatus for manufacturing a highly-versatile solar cell with excellent yields and productivity are provided. The method includes forming a belt-like first electrode layer 12 on a substrate 11, forming a belt-like semiconductor layer 13 on the first electrode layer 12, and forming a belt-like second electrode layer 14 on the semiconductor layer 13. At least one electrode layer selected from the first electrode layer 12 and the second electrode layer 14 is divided by (a) applying a liquid resist so as to form a striped resist pattern, (b) forming the at least one electrode layer so as to cover the resist pattern, and (c) removing both the resist pattern and the at least one electrode layer formed on the resist pattern.

## Description

The present invention relates to an integrated solar cell in which a plurality of unit cells are connected in series, a method for manufacturing the same, and an apparatus for manufacturing the same.

Conventionally, there have been reports on the structure and manufacturing method for a thin-film solar cell module using CuInSe₂ (CIS), Cu(In, Ga)Se₂ (CIGS), which is a solid solution of CIS with Ga, or CuInS₂ as a light-absorption layer (for example, see 13TH EUROPEAN PHOTOVOLTAIC SOLAR CONFERENCE 1995, pages 1451 - 1455). CIS, CIGS and CuInS₂ are compound semiconductors (of chalcopyrite structure) comprising at least one element from each of groups Ib, IIIb and VIb. Such CIS thin-film solar cells generally have an integrated structure in which a plurality of unit cells are connected in series on a substrate.

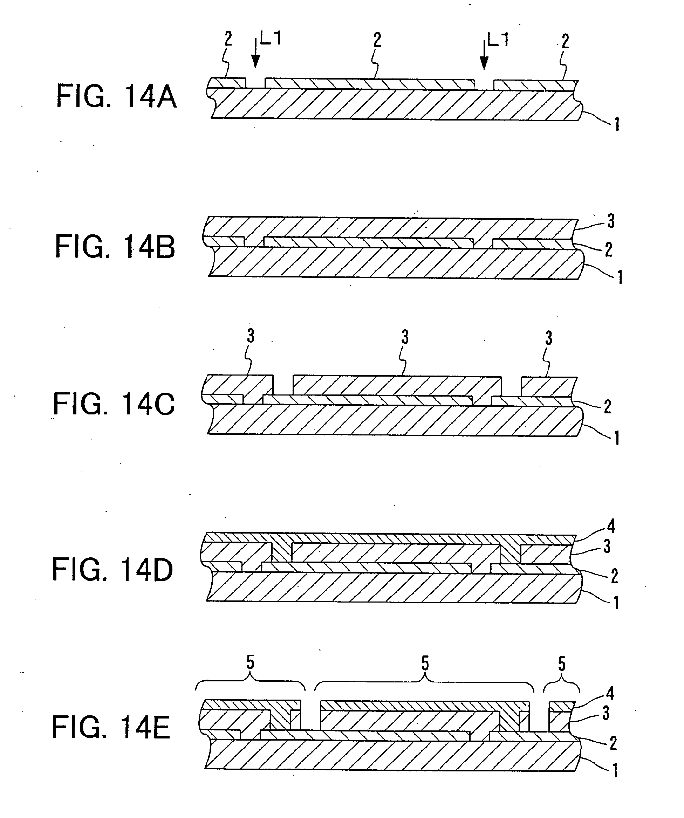

An example of a conventional method for manufacturing the CIS solar cells will be described referring to FIGs. 14A to 14E. First, as shown in FIG. 14A, a first electrode layer 2 is formed on an electrically insulating substrate 1 such as a glass substrate by sputtering and then is irradiated with a continuous-wave laser beam L1, thereby removing the first electrode layer 2 in a striped manner so as to obtain belt-like first electrode layers 2. Thereafter, as shown in FIG. 14B, a semiconductor layer 3 in which a p-type Cu(In, Ga)Se₂ thin-film and an n-type CdS thin-film are layered is formed. Then, as shown in FIG. 14C, the semiconductor layer 3 is divided into belt-like portions by mechanical scribing. Subsequently, as shown in FIG. 14D, a transparent conductive film is formed as a second electrode layer 4. Finally, as shown in FIG. 14E, the second electrode layer 4 is divided into belt-like portions by mechanical scribing. In the solar cell shown in FIG. 14E, the second electrode layer 4 of each unit cell 5 is connected to the first electrode layer 2 of its adjacent unit cell 5, so that these unit cells 5 are connected in series. Incidentally, in the processes of FIGs. 14C and 14E, the division also can be made by using a laser beam instead of mechanical scribing.

In such integrated thin-film solar cells, the general versatility improves by using a flexible substrate such as a stainless-steel substrate. Furthermore, using a flexible substrate is advantageous in terms of manufacture because this makes it possible to pull out the substrate wound around a roller and form solar cells continuously thereon.

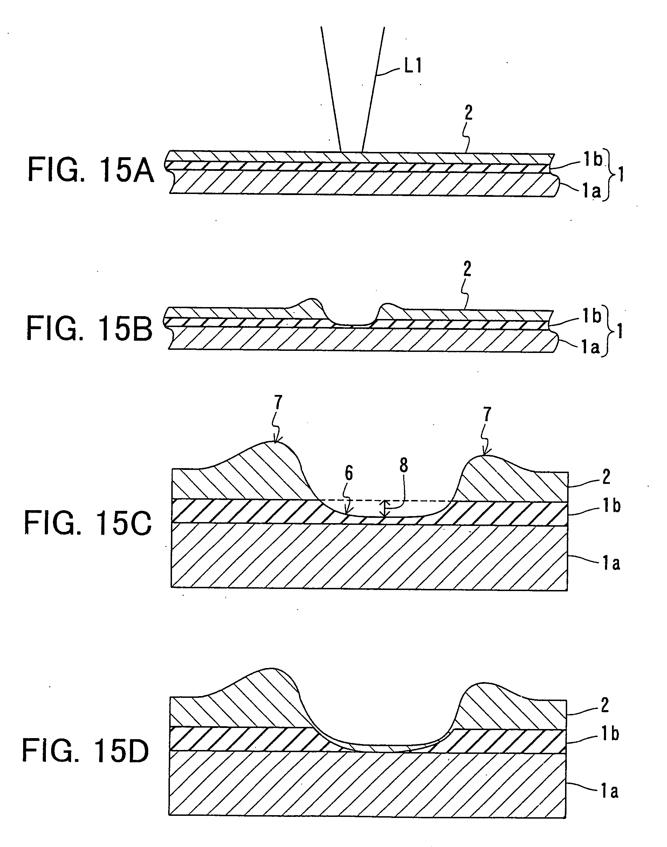

However, when a nontransparent substrate such as a stainless-steel substrate is used, there has been a problem in that short circuit occurs easily at the time of removing the electrode layer in a striped manner by a laser beam. The following is a description of the case where a stainless-steel substrate is irradiated with a laser beam, with reference to FIGs. 15A to 15D. As shown in FIG. 15A, a substrate 1 includes a stainless-steel substrate 1a having electrical conductivity and an insulating layer (SiO₂ layer) 1b formed to provide an insulating property. A first electrode layer 2 is formed on the substrate 1. When this substrate is irradiated with a laser beam L1, not only the first electrode layer 2 but also the stainless-steel substrate 1a and the insulating layer 1b sometimes are processed as shown in FIG. 15B. FIG. 15C is an enlarged view of FIG. 15B. As shown in FIG. 15C, there are some cases where the irradiation with the laser beam L1 cuts out a part of the insulating layer 1b so as to form a depression 6. The depression 6 sometimes has a depth 8 of 100 nm or more. As shown in FIG. 15C, there also are some cases where the first electrode layer 2 in a part that is irradiated with the laser beam L1 melts so as to form a protrusion 7. Furthermore, as shown in FIG. 15D, there are some cases where the insulating layer 1b is removed, so that the first electrode layer 2 and the stainless-steel substrate 1a are short-circuited. When the substrate and the electrode layer are short-circuited, the unit cells 5 become short-circuited. Thus, as described above, forming grooves by the laser beam L1 has increased the risk of a short circuit.

On the other hand, it is possible to process the electrode layer in a striped manner with a photolithographic and etching technique. However, this method has the following problems: (1) many processes are needed, (2) there are some constraints on the dimension and shape of the substrate, and (3) continuous production is difficult.

In view of such problems, it is an object of the present invention to provide a method and an apparatus for manufacturing an integrated solar cell with excellent yields and productivity.

A manufacturing method of the present invention is a method for manufacturing a solar cell including a substrate having an insulating surface, and a plurality of unit cells that are formed on the surface and connected in series. The method includes (i) forming a first electrode layer on the surface of the substrate, (ii) removing a part of the first electrode layer in a striped manner so as to divide the first electrode layer, (iii) forming a semiconductor layer including a pn junction on the first electrode layer, (iv) removing a part of the semiconductor layer in a striped manner so as to divide the semiconductor layer, (v) forming a second electrode layer on the semiconductor layer and the first electrode layer that has been exposed by removing the semiconductor layer, and (vi) removing a part of the second electrode layer in a striped manner so as to divide the second electrode layer. At least one electrode layer selected from the first electrode layer and the second electrode layer is divided by a process including (a) applying a liquid resist so as to form a striped resist pattern, (b) forming the at least one electrode layer so as to cover the resist pattern, and (c) removing both the resist pattern and the at least one electrode layer formed on the resist pattern.

In other words, the manufacturing method of the present invention includes (I) forming a belt-like first electrode layer on a substrate, (II) forming a belt-like semiconductor layer on the first electrode layer, and (III) forming a belt-like second electrode layer on the semiconductor layer. At least one of the (I) forming and the (III) forming includes the (a) applying, the (b) forming and the (c) removing.

Also, an apparatus for manufacturing a solar cell according to the present invention is an apparatus for manufacturing a solar cell including a substrate, and an electrode layer disposed on the substrate. The apparatus includes a resist pattern forming system for applying a liquid resist on the substrate so as to form a striped resist pattern.

The above-described manufacturing apparatus further may include an electrode layer forming system for forming the electrode layer so as to cover the resist pattern, and a removing system for removing the resist pattern and the electrode layer formed on the resist pattern.

In the above-described manufacturing apparatus, the substrate may be flexible, and the apparatus further may include a first roller, around which the substrate is wound, for supplying the substrate to the resist pattern forming system, and a second roller for taking up the substrate on which the resist pattern has been formed.

In the above-described manufacturing apparatus, the resist pattern forming system may include an orifice-like nozzle for applying the liquid resist.

In the above-described manufacturing apparatus, the resist pattern forming system further may include a member for charging the liquid resist, and the nozzle may include a member for expelling the charged liquid resist by an electrostatic force.

In the above-described manufacturing apparatus, the resist pattern forming system may include a first roller including a printing plate for disposing the liquid resist in a striped manner, a second roller for pressing the substrate against the first roller, and a liquid resist supplying system for supplying the liquid resist to the printing plate.

In the above-described manufacturing apparatus, the resist pattern forming system may include a discharge portion with a nozzle for discharging the liquid resist and a supporting portion for supporting the discharge portion, and the supporting portion may be capable of changing an angle that a central axis of the nozzle forms with the substrate.

Furthermore, a solar cell of the present invention includes a substrate having an insulating surface, and a plurality of unit cells that are formed on the surface and connected in series. The solar cell includes a first electrode layer, a semiconductor layer and a second electrode layer that are layered sequentially from a side of the substrate. The first electrode layer is divided by a striped groove, and the surface of the substrate is flat in a portion of the groove. In the present specification, being "flat" means that the depth of the depression or the height of the protrusion is not greater than 50 nm. For example, it means that in FIG. 15C the depth 8 of the depression 6 is not greater than 50 nm.

FIGs. 1A to 1E are sectional views showing an exemplary process flow of a method for manufacturing a solar cell, according to the present invention.

FIGs. 2A, 2B and 2C are plan views of FIGs. 1A, 1C and 1E, respectively.

FIGs. 3A to 3D are sectional views showing an example of one process in the method for manufacturing a solar cell, according to the present invention.

FIGs. 4A and 4B are plan views of FIGs. 3A and 3B, respectively.

FIG. 5 shows an example of an apparatus for manufacturing a solar cell, according to the present invention.

FIG. 6A is a schematic view showing an example of a part of the manufacturing apparatus according to the present invention, and FIG. 6B is a plan view showing a nozzle portion.

FIG. 7 is a schematic view showing another example of the part of the manufacturing apparatus according to the present invention.

FIG. 8 is a schematic view showing a still further example of the part of the manufacturing apparatus according to the present invention.

FIG. 9 is a sectional view showing part of the manufacturing apparatus shown in FIG. 8.

FIG. 10 is a perspective view schematically showing how the manufacturing apparatus shown in FIG. 8 works.

FIG. 11 is a schematic view showing a still further example of the part of the manufacturing apparatus according to the present invention.

FIG. 12 is a schematic view showing a still further example of the part of the manufacturing apparatus according to the present invention.

FIG. 13 is a schematic view showing a still further example of the manufacturing apparatus according to the present invention.

FIGs. 14A to 14E are sectional views showing an exemplary process flow of a conventional method for manufacturing a solar cell.

FIGs. 15A to 15D are sectional views showing an example of one process in the conventional method for manufacturing a solar cell.

The following is a description of embodiments of the present invention, with reference to the accompanying drawings. In the following embodiments, common portions are assigned the same numerals, and the overlapping descriptions thereof will be omitted in some cases.

### First Embodiment

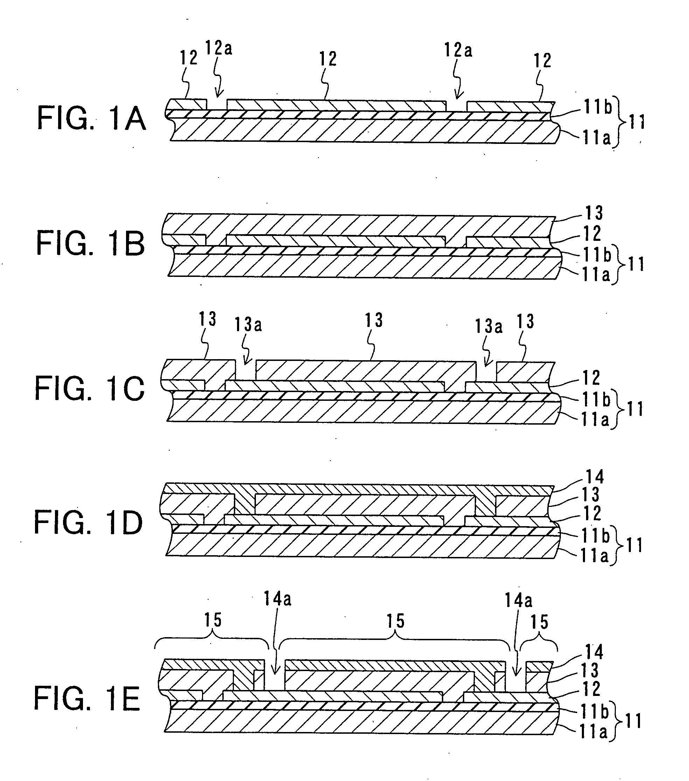

The first embodiment is directed to a method for manufacturing a solar cell according to the present invention. In the manufacturing method of the first embodiment, first, a first electrode layer 12 is formed on a substrate 11 (process (i)). Then, as shown in FIG. 1A, a part of the first electrode layer 12 is removed in a striped manner so as to form grooves 12a, thereby dividing the first electrode layer 12 into belt-like portions (process (ii)). The processes (i) and (ii) will be detailed later.

The substrate 11 includes a substrate 11a and an insulating layer 11b formed on the substrate 11a. The substrate 11a can be a flexible metal plate, for example, a stainless-steel sheet. The insulating layer 11b can be a SiO₂ film or the like, which can be formed by a CVD method. The insulating layer 11b may be replaced with a substrate whose surface is subjected to an insulating treatment. At least one surface of the substrate 11 has an electrically insulating property, and the first electrode layer 12 is formed on this insulating surface. Alternatively, the substrate 11 entirely may have an insulating property and can be, for example, a polyimide substrate or a polyethylene terephthalate substrate. When the substrate 11a is formed of stainless steel, it has a thickness ranging from 20 µm to 200 µm, for example. The insulating layer 11b has a thickness ranging from 0.05 µm to 1.0 µm, for example. It is preferable that the substrate 11 is flexible and can be taken up by a roller. The first electrode layer 12 is made of metal such as molybdenum (Mo) and can be formed by sputtering or vapor deposition.

Next, as shown in FIG. 1B, a semiconductor layer 13 including a pn junction is formed on the first electrode layer 12 (process (iii)). The semiconductor layer 13 includes a p-type semiconductor layer and an n-type semiconductor layer. The p-type semiconductor can be, for example, a semiconductor having a chalcopyrite structure. Specifically, a semiconductor comprising at least one element from each of groups Ib, IIIb and VIb can be used. As the element from group Ib, Cu can be used. As the element from group IIIb, at least one element selected from In and Ga can be used. As the element from group VIb, at least one element selected from Se and S can be used. More specifically, CuInSe₂ (CIS), Cu(In, Ga)Se₂ (CIGS), which is a solid solution of CIS with Ga, or a semiconductor obtained by substituting a part of Se in these CIS and CIGS with sulfur can be used. They can be formed by vapor deposition or sputtering. On the other hand, the n-type semiconductor can be a compound comprising at least one element from each of groups II and VIb, for example, CdS, ZnO, Zn(O, OH) or Zn(O, OH, S). They can be formed by a chemical bath deposition process or sputtering. Incidentally, a part of the semiconductor layer 13 may include other layers such as a very thin insulating layer.

Next, as shown in FIG. 1C, a part of the semiconductor layer 13 is removed in a striped manner so as to form grooves 13a, thus dividing the semiconductor layer 13 into belt-like portions (process (iv)). The grooves 13a are formed at positions that expose a part of the first electrode layer 12, for example, next to the grooves 12a. A part of the semiconductor layer 13 can be removed by mechanical scribing or laser scribing.

Then, as shown in FIG. 1D, a second electrode layer 14 is formed on the semiconductor layer 13 and on the first electrode layer 12 exposed by removing the semiconductor layer 13 (process (v)). The second electrode layer 14 also is formed in the part of the grooves 13a, through which the first electrode layer 12 and the second electrode layer 14 are connected electrically. The second electrode layer 14 can be a transparent conductive film such as a ZnO film, an Al-doped ZnO film or an ITO film. The second electrode layer 14 can be formed by sputtering or a CVD method, for example.

Finally, as shown in FIG. 1E, a part of the second electrode layer 14 is removed in a striped manner so as to form grooves 14a, thus dividing the second electrode layer 14 into belt-like portions (process (vi)). In the process (vi), as shown in FIG. 1E, not only the second electrode layer 14 but also a part of the semiconductor layer 13 may be removed. The grooves 14a usually are formed next to the grooves 13a. How to remove a part of the second electrode layer 14 will be explained later.

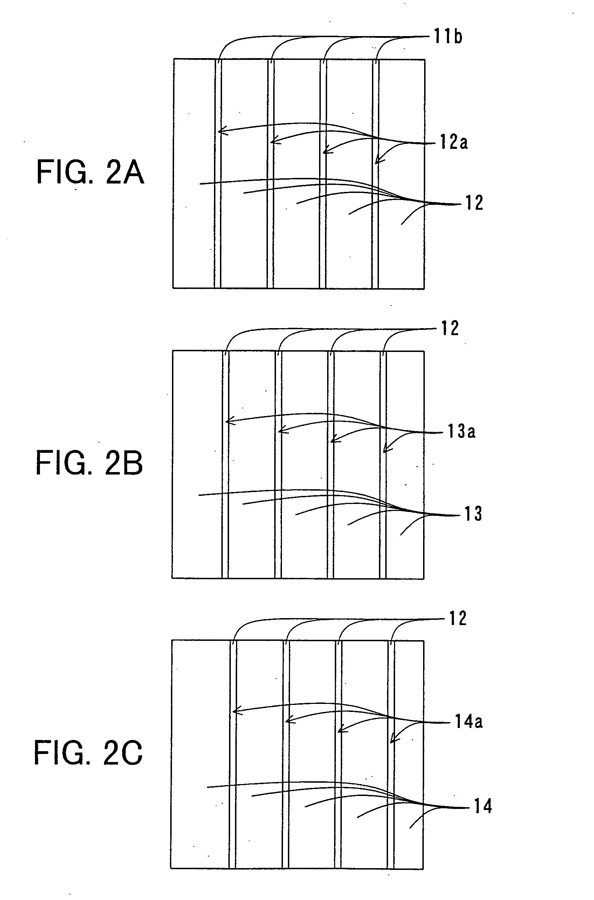

In this manner, a solar cell in which a plurality of the unit cells 15 are formed on the substrate 11 and connected in series can be produced. Each of the unit cells 15 functions as one solar cell. The second electrode layer 14 of each unit cell 15 is connected to the first electrode layer 12 of the adjacent unit cell 15, whereby adjacent unit cells are connected in series. FIGs. 2A, 2B and 2C are plan views showing processes of FIGs. 1A, 1C and 1E, respectively.

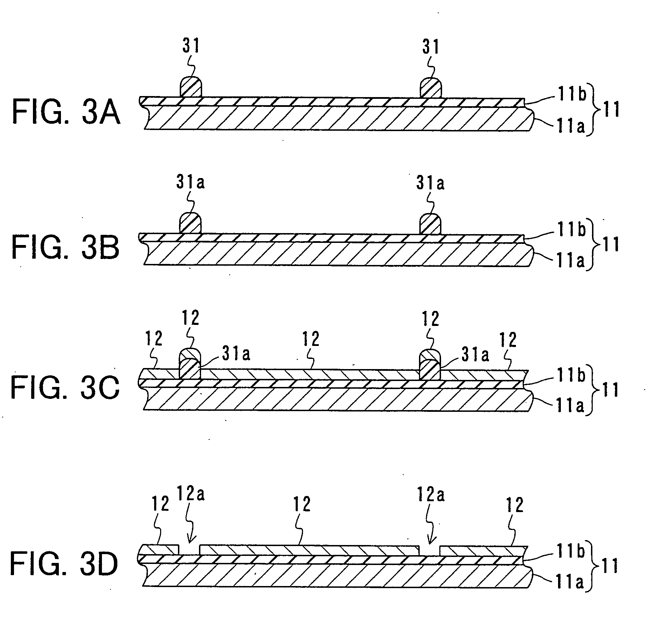

In the following, an exemplary method for removing a part of the first electrode layer 12 so as to form the grooves 12a will be described. This process is illustrated in FIG. 3.

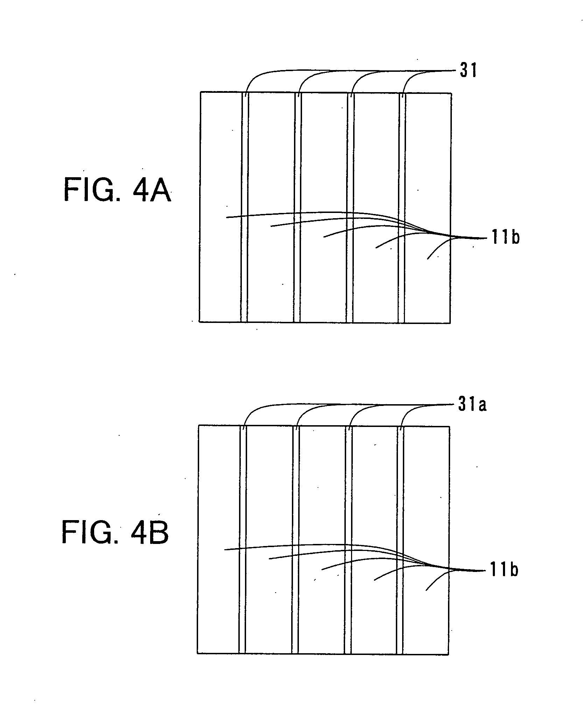

First, as shown in FIG. 3A, a liquid resist 31 is applied in a striped manner on the substrate 11. FIG. 4A is a plan view of FIG. 3A. The disposed liquid resist 31 usually has a width ranging from 50 µm to 500 µm. The interval (pitch) between stripes of the liquid resist 31 usually ranges from 3 mm to 8 mm and is usually constant.

The liquid resist can be applied by putting the liquid resist in a container having a discharge port and releasing it from the discharge port. This discharge port can be, for example, a general nozzle or an orifice-like nozzle. The orifice-like nozzle means a nozzle formed in a flat surface. A first method for applying the liquid resist includes using a discharge portion (transducer) formed of a piezo-element or a thermal element so as to adjust a pressure applied to the liquid resist, and allowing the liquid resist 31 to discharge from the nozzle. A second method for applying the liquid resist includes charging the liquid resist 31, subjecting it to an electrostatic force and allowing it to discharge from a nozzle. The third method includes putting the liquid resist 31 in a container having a nozzle and applying a pressure to this container, thereby allowing the liquid resist to discharge from the nozzle. In this case, the liquid resist 31 may be applied by allowing it to discharge from the nozzle while keeping the nozzle in contact with the substrate. The angle that a central axis of the nozzle forms with the substrate preferably ranges from 0° to 60° (more preferably, from 5° to 45°). It also is preferable that the container is supported so as to allow changes in the above-mentioned angle and supported elastically. Furthermore, the fourth method for applying the liquid resist includes arranging the liquid resist in a striped manner by using a roller for printing the liquid resist in a predetermined pattern. A device and a method for applying the liquid resist 31 in a striped manner will be described in the embodiments below.

Then, as shown in FIG. 3B, the liquid resist 31 disposed in a striped manner is fixed (hardened), thus forming a striped resist pattern 31a. FIG. 4B is a plan view of FIG. 3B. When the liquid resist 31 is a photocurable material such as an UV curable resin, it is irradiated with ultraviolet light or the like (for example, light with a wavelength ranging from 300 nm to 400 nm). When the liquid resist 31 has a thermosetting property, it is fixed by heating. The liquid resist 31 also can be hardened by air drying depending on the material thereof. In this manner, a striped resist pattern is formed (process (a)).

Subsequently, as shown in FIG. 3C, the first electrode layer 12 is formed so as to cover the resist pattern 31a (process (b)). At this time, the first electrode layer 12 formed on the resist pattern 31a is spaced from the substrate 11 by the thickness of the resist pattern 31a.

Thereafter, as shown in FIG. 3D, the resist pattern 31a and the first electrode layer 12 formed on the resist pattern 31a are removed (process (c)). By removing the resist pattern 31a, the first electrode layer 12 formed thereon can be removed at the same time. In this manner, the first electrode layer 12 can be divided into belt-like portions.

When the first electrode layer 12 is formed of metal such as molybdenum, it has a thickness of about 0.2 µm to 2 µm. In order to remove the first electrode layer 12 efficiently, it is preferable that the resist pattern 31a is ten times as thick as the first electrode layer 12. In order to form such a thick resist pattern 31a, it is preferable that the liquid resist 31 contains inorganic compound powder and a resin. More specifically, a liquid containing inorganic compound powder, a resin and an organic solvent can be used as the liquid resist 31. The inorganic compound powder can be, for example, barium sulfate powder or calcium carbonate powder. These powders have a mean particle diameter (preferably, a particle diameter) ranging from 60 nm to 700 nm, for example. As the resin, acrylic resin can be used, for example. As the organic solvent, isopropyl alcohol and methyl alcohol can be used, for example. By changing the particle diameter of the inorganic compound powder and the content of the resin, it is possible to change the thickness of the resist pattern to be formed. For example, a liquid obtained by mixing 60 wt% of barium sulfate powder with a mean particle diameter of 70 nm, 20 wt% of methyl alcohol, 8 wt% of isopropyl alcohol and 12 wt% of acrylic resin can be used as the liquid resist. After being applied, this liquid resist hardens due to the evaporation of the organic solvent, thus forming the resist pattern. Since the formed resist pattern has a weak adhesion to the substrate, it peels off easily from the substrate when being washed with a liquid (for example, water).

When the liquid resist 31 contains a water-soluble polymer compound (such as a water-soluble resin) or when the liquid resist 31 is a water-soluble ink, the resist pattern 31a can be removed by using a liquid that contains water (for example, water). Also, when the liquid resist 31 contains a polymer compound that is soluble in an organic solvent, the resist pattern 31a can be removed by using an organic solvent.

One method for removing the resist pattern 31a can include ultrasonic cleaning in a liquid. However, when the liquid resist is highly viscous, a cleaning method using a mechanical means such as cleaning with a brush may be adopted. Also, before cleaning, most of the resist pattern 31a may be peeled off by grinding or the like, and then residue may be removed by cleaning with a liquid.

The resist pattern 31a also may be removed by a physical method or thermal evaporation other than using the liquid. The physical method can include grinding the resist pattern 31a mechanically.

In this manner, a part of the first electrode layer 12 is removed so as to divide the first electrode layer 12 into belt-like portions. Although the above description is directed to the method for dividing the first electrode layer 12, the method of the present invention is appropriate as long as at least one electrode layer selected from the first electrode layer 12 and the second electrode layer 14 is divided into belt-like portions by the processes (a) to (c) described above. When the second electrode layer 14 is removed by the processes (a) to (c), it is appropriate to form the resist pattern on the semiconductor layer 13 in the process (a). In any cases, the resist pattern is formed on a base (the substrate or the semiconductor layer). When the processes (a) to (c) are not employed, mechanical scribing can be used. In addition, the second electrode layer 14 may be divided using a laser beam.

According to the above-described manufacturing method of the present invention, it is possible to manufacture a solar cell with excellent yields and productivity even when using a flexible substrate. In the conventional method, there have been some cases where the substrate in a groove portion is damaged or the first electrode layer in the groove portion melts and rises, as shown in FIG. 15C. On the other hand, in the solar cell manufactured by the method of the present invention, the substrate in the groove portion remains flat and the first electrode layer in the groove portion does not melt. Therefore, fewer short circuits occur in the groove portion in this solar cell.

### Second Embodiment

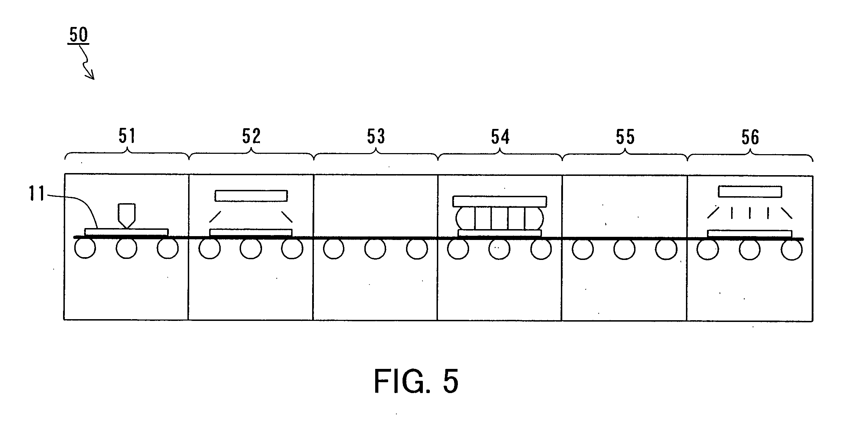

The second embodiment is directed to an example of an apparatus for manufacturing a solar cell according to the present invention. A manufacturing apparatus 50 of the second embodiment is shown schematically in FIG. 5. The manufacturing apparatus 50 is an apparatus for forming a belt-like electrode layer.

Referring to FIG. 5, the manufacturing apparatus 50 includes a pattern forming portion 51, a fixing portion 52, a backup chamber 53, an electrode layer forming portion 54, a backup chamber 55 and a removing portion 56 that are lined up in one direction. Although FIG. 5 illustrates the case of using a cut substrate 11, a long substrate may be used and processed continuously.

The pattern forming portion 51 and the fixing portion 52 function as a pattern forming system for forming a striped resist pattern. In the pattern forming portion 51, the liquid resist is applied onto the substrate 11 in a striped manner. The pattern forming portion 51 will be detailed later.

The fixing portion 52 fixes the liquid resist 31 that has been arranged in a striped manner. The configuration of the fixing portion 52 varies depending on the kinds of the liquid resist. When the liquid resist 31 is a photocurable material such as an UV curable resin, the fixing portion 52 is provided with a light source for an irradiation of ultraviolet light or the like (for example, light with a wavelength ranging from 300 nm to 400 nm). When the liquid resist 31 is a thermosetting resin, the fixing portion 52 is provided with a heating device.

The electrode layer forming portion 54 functions as a system for forming an electrode layer. The electrode layer forming portion 54 is decompressed constantly for the duration of the electrode layer formation. Since the decompressed state in the electrode layer forming portion 54 can be maintained by the backup chambers 53 and 55, tact time (time required for one process) can be reduced. The electrode layer forming portion 54 is provided with a device for forming an electrode layer such as a deposition device or a sputtering device.

The removing portion 56 functions as a system for removing both the resist pattern 31a and the electrode layer formed on the resist pattern 31a. When they are removed by using a liquid, the removing portion 56 is provided with, for example, a device for cleaning by a jet of liquid. When they are removed physically, the removing portion 56 is provided with a scraper or the like.

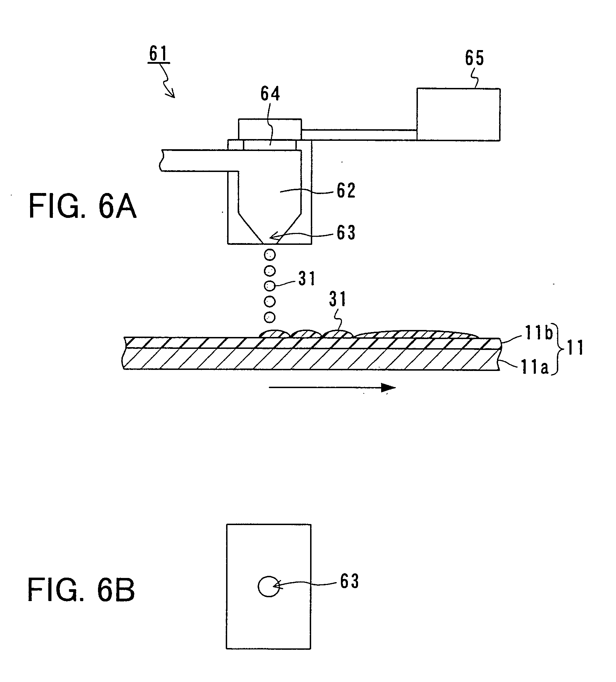

The following is a description of four examples of a device for applying the liquid resist, used in the pattern forming portion 51. First, a printing head 61 for printing the liquid resist is shown in FIG. 6A, as the first example.

Referring to FIG. 6A, the printing head 61 includes an ink chamber 62, a nozzle portion 63, a transducer 64 and a control portion 65. The ink chamber 62 holds the liquid resist 31. The nozzle portion 63 drops the liquid resist 31 contained in the ink chamber 62. The transducer 64 is formed of a piezo-element or a thermal element and has a function of allowing the liquid resist 31 to discharge. When the transducer 64 warps, this increases/ decreases the inner volume of the ink chamber 62, thus allowing the liquid resist to discharge from the nozzle portion 63. The control portion 65 outputs a signal for controlling the shape of the transducer 64 (for example, voltage) to the transducer 64. Since the printing head 61 is provided with a plurality of the nozzle portions 63 that are arranged at constant intervals, the liquid resist 31 is dropped while moving the substrate 11 in an arrow direction shown in FIG. 6A, so that the liquid resist 31 is disposed in a striped manner. FIG. 6B shows an orifice-like nozzle portion 63 seen from the side of the substrate 11. The nozzle portion 63 is a hole formed in a flat surface.

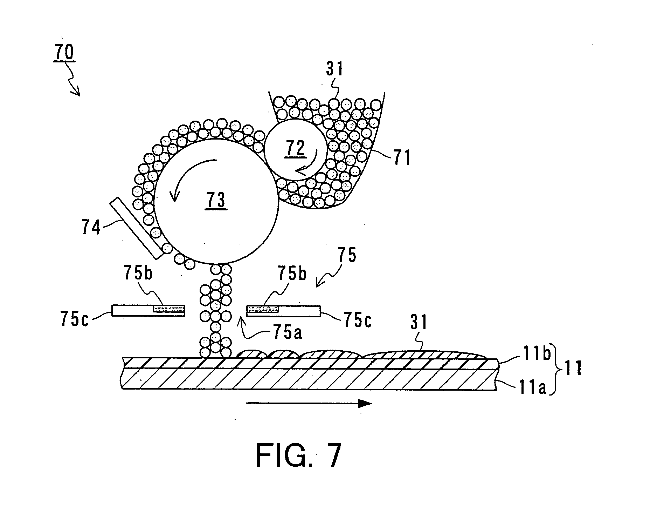

Next, FIG. 7 shows an applicator 70 as the second example of the device for forming the resist pattern. Although the liquid resist 31 is illustrated as particles in a part of FIG. 7 in order to facilitate understanding, it is liquid in practice. Referring to FIG. 7, the applicator 70 includes a hopper 71, a first roller 72, a second roller 73, a blade 74 and a nozzle 75. Although FIG. 7 shows a roller-like second roller 73, a liquid resist supplying member is not limited to this but may be a belt-like member, for example. The nozzle 75 is constituted by a flexible printed circuit board (FPC) 75c including a hole 75a through which the liquid resist 31 passes and a control electrode 75b.

The liquid resist 31 is contained in the hopper 71. When the first roller 72 arranged inside the hopper 71 rotates, the liquid resist 31 in the hopper 71 is supplied to the second roller 73. The liquid resist 31 moves along a perimeter of the rotating second roller 73, is rubbed by the blade 74 so as to be charged negatively, and limited to a thickness corresponding to one to three layers, and then arrives at the nozzle 75. As described above, the second roller 73 and the blade 74 function as a means for charging the liquid resist. Voltage is applied to the control electrode 75b of the nozzle 75, and the liquid resist 31 is expelled from the hole 75a due to an electrostatic force generated between the control electrode 75b and the liquid resist 31. In other words, the control electrode 75b functions as a member for expelling the liquid resist 31 by an electrostatic force.

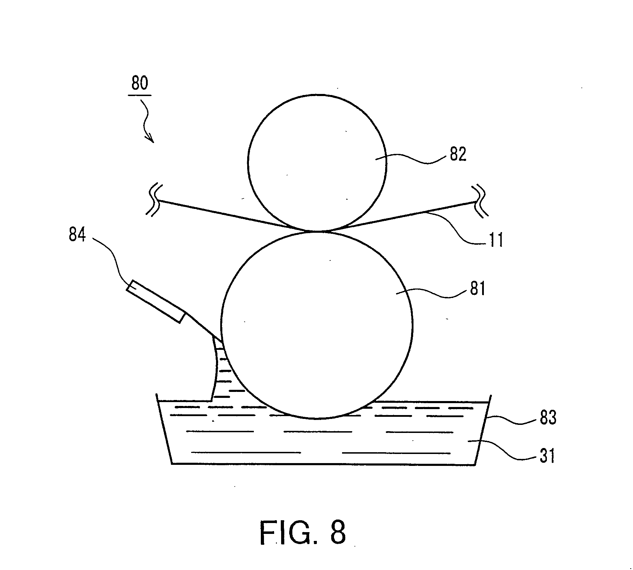

Next, the third example of the device for forming the resist pattern will be described. FIG. 8 schematically shows a cross-section of an applicator 80. Referring to FIG. 8, the applicator 80 includes a first roller 81, a second roller 82, a container 83 and a blade portion 84. The substrate 11 passes between the first roller 81 and the second roller 82.

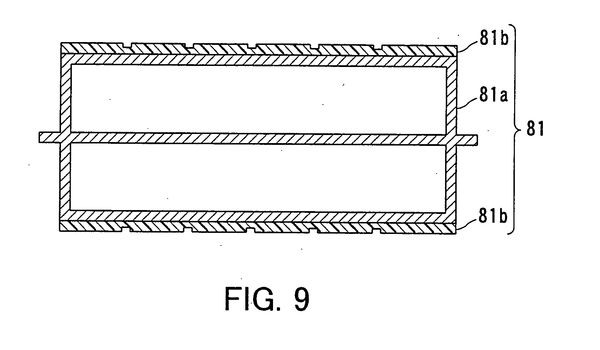

The container 83 holds the liquid resist 31. The container 83 supplies the liquid resist 31 to the first roller 81, whose cross-section is shown in FIG. 9. The first roller 81 includes a roller 81a. The surface of the roller 81a is provided with a printing plate 81b for applying the liquid resist 31 in a striped manner onto the substrate 11.

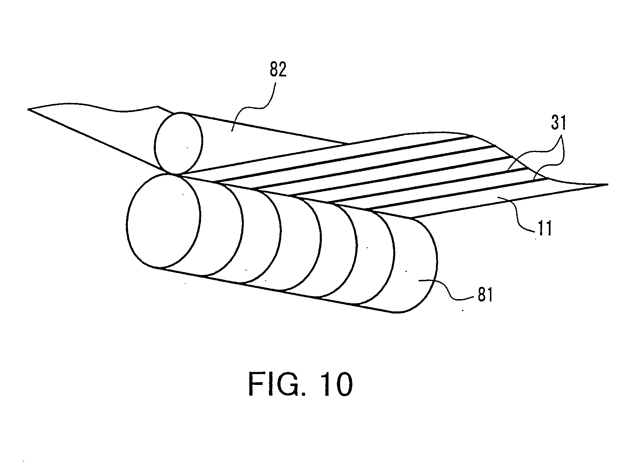

A part of the first roller 81 is immersed in the liquid resist 31, and by the rotation of the first roller 81, the liquid resist 31 is supplied from the container 83 to the printing plate of the first roller 81. At this time, the liquid resist 31 is filled in an incised portion of the printing plate of the first roller 81. The substrate 11 is pressed against the first roller 81 by the second roller 82, and the liquid resist 31 filled in the incised portion is transferred to the substrate 11 and disposed in a striped manner. FIG. 10 schematically shows how the liquid resist 31 is disposed. As another method for supplying the liquid resist 31 to the first roller 81, the liquid resist 31 may be sprayed on the first roller 81.

In order to print the liquid resist 31, it is necessary to press the substrate 11 sufficiently against the first roller 81 using the second roller 82. Accordingly, the second roller 82 may include a metal cylinder and a rubber wound around this cylinder.

The blade portion 84 is a device for scraping an excess liquid resist 31 adhering to the first roller 81 and has a function of controlling the amount of the liquid resist 31 adhering to the first roller 81. A thin steel plate can be used for the blade portion 84.

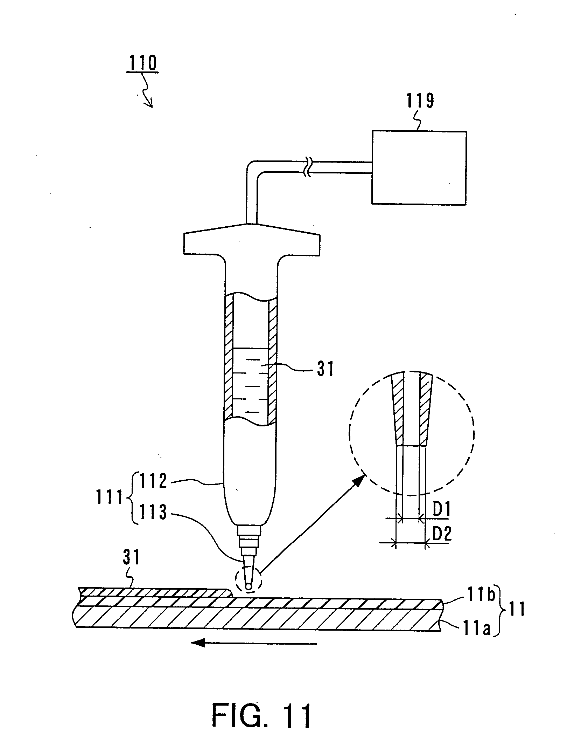

Now, the fourth example of the device for forming the resist pattern will be described. FIG. 11 shows a schematic configuration of an applicator 110. The applicator 110 includes a discharge device 111 and a control portion 119.

The discharge device 111 includes a cylindrical container 112 and a nozzle 113 arranged at the tip of the container 112. FIG. 11 also shows an enlarged view of the tip of the nozzle 113. Here, the inner diameter of the tip of the nozzle 113 is expressed by D1, and the outer diameter thereof is expressed by D2. The liquid resist 31 is held in the container 112 and discharged from the nozzle 113.

The control portion 119 applies a certain pressure to the container 112, thereby controlling the amount of the liquid resist 31 discharged from the nozzle 113. The control portion 119 includes a pressurizing device (for example, a pump) for applying a pressure to the container 112 and a regulator for controlling the pressure applied to the container 112. It is preferable that the applicator 110 includes a measuring system for measuring the amount of the liquid resist 31 discharged from the nozzle 113. Then, based on the value obtained by this measuring system, the pressure in the container 112 preferably is controlled.

The applicator 110 drops a constant amount of the liquid resist 31 while moving the substrate 11, so that the liquid resist with a constant width can be applied. Also, a plurality of the applicators 110 are arranged at constant intervals so as to apply the liquid resist, thereby forming a striped resist pattern.

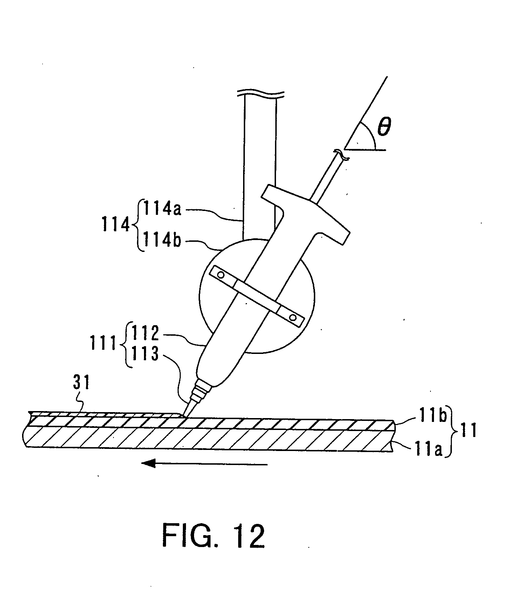

As shown in FIG. 12, when applying the liquid resist 31, it may be possible to bring the nozzle 113 into direct contact with the substrate 11. In this case, the discharge device 111 is supported by a supporting portion 114. The supporting portion 114 includes a supporting member 114a formed of an elastic material and a rotating portion 114b for changing an angle of the discharge device 111. The supporting member 114a can be, for example, a member using a spring or an air cylinder. The rotating portion 114b can keep an angle θ that the central axis of the nozzle 113 forms with the surface of the substrate 11 constant. The angle θ preferably ranges from 0° to 60° (more preferably, from 5° to 45°).

When the nozzle does not contact the substrate, the liquid drops discharged from the nozzle grow to a size of the outer diameter D2 and then are applied. Therefore, the width of the resist pattern varies depending on the outer diameter D2 of the nozzle. In the device shown in FIG. 12, since the tip of the nozzle is brought into contact with the substrate while keeping the angle θ constant, the liquid drops are discharged maintaining the size of the inner diameter D1 of the nozzle. As a result, the width of the resist pattern 31a to be formed can be made substantially equal to the inner diameter D1 of the nozzle (see FIG. 11). Thus, the device shown in FIG. 12 can form a still finer resist pattern 31a. Since this device includes the supporting member 114a formed of an elastic material, it is possible to prevent the nozzle 113 from coming away from the substrate 11 even when the substrate 11 warps.

### Third Embodiment

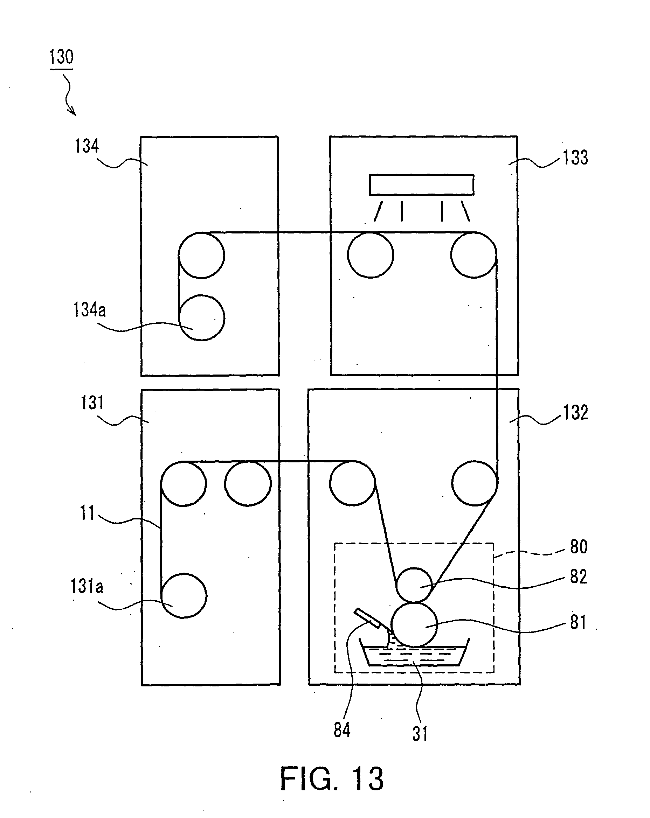

The third embodiment is directed to an exemplary manufacturing apparatus using the applicator 80 described in the second embodiment. FIG. 13 shows a schematic configuration of a manufacturing apparatus 130 of the third embodiment. The manufacturing apparatus 130 is an apparatus for forming a striped resist pattern. The applicator 80 may be replaced with any of the applicators shown in FIGs. 6, 7, 11 and 12.

The manufacturing apparatus 130 includes a supplying portion 131, a resist printing portion 132, a fixing portion 133 and a take-up portion 134. The supplying portion 131 includes a feed roller 131a storing the substrate 11 in a wound form and supplies the substrate 11. The resist printing portion 132 includes the applicator 80 described in the second embodiment and prints the liquid resist in a predetermined pattern on the substrate 11. The fixing portion 133 fixes the liquid resist printed on the substrate 11. When using the liquid resist to be fixed by heating, the fixing portion 133 includes a heating device such as a heater. When an UV curable resin is used for the liquid resist, the fixing portion 133 includes an ultraviolet light irradiation device such as an UV lamp. The take-up portion 134 includes a take-up roller 134a for taking up the substrate 11 on which the predetermined resist pattern has been formed. By using the manufacturing apparatus 130 as described above, it is possible to form a predetermined resist pattern continuously on the long substrate 11.

## Claims

1. A method for manufacturing a solar cell comprising a substrate having an insulating surface, and a plurality of unit cells that are formed on the surface and connected in series, the method comprising:
(i) forming a first electrode layer on the surface of the substrate;
(ii) removing a part of the first electrode layer in a striped manner so as to divide the first electrode layer;
(iii) forming a semiconductor layer including a pn junction on the first electrode layer;
(iv) removing a part of the semiconductor layer in a striped manner so as to divide the semiconductor layer;
(v) forming a second electrode layer on the semiconductor layer and the first electrode layer that has been exposed by removing the semiconductor layer; and
(vi) removing a part of the second electrode layer in a striped manner so as to divide the second electrode layer;
wherein at least one electrode layer selected from the first electrode layer and the second electrode layer is divided by a process comprising
(a) applying a liquid resist so as to form a striped resist pattern,
(b) forming the at least one electrode layer so as to cover the resist pattern, and
(c) removing both the resist pattern and the at least one electrode layer formed on the resist pattern.

2. The method according to claim 1, wherein the substrate is flexible.

3. The method according to claim 1 or 2, wherein the semiconductor layer comprises a compound semiconductor layer comprising at least one element from each of groups Ib, IIIb and VIb.

4. The method according to claim 1, 2, or 3, wherein, in the (a) applying, the liquid resist is put in a container having a discharge port and released from the discharge port, thus disposing it in a striped manner.

5. The method according to claim 4, wherein the liquid resist is released from the discharge port by applying a pressure to the liquid resist in the container.

6. The method according to claim 5, wherein the liquid resist is applied while keeping the discharge port in contact with the substrate.

7. The method according to claim 4, wherein the discharge port is an orifice-like nozzle.

8. The method according to claim 7, wherein, in the (a) applying, the liquid resist is charged and then subjected to an electrostatic force, thereby allowing it to be expelled from the nozzle.

9. The method according to claim 1, 2, or 3, wherein, in the (a) applying, the liquid resist is disposed in a striped manner by using a roller provided with a printing plate.

10. The method according to any of claims 1 to 9, wherein the liquid resist is an UV curable resin, and the liquid resist that has been applied is irradiated with ultraviolet light, thus forming the resist pattern.

11. The method according to any of claims 1 to 9, wherein the liquid resist contains a water-soluble polymer compound, and, in the (c) removing, the resist pattern and the at least one electrode layer formed on the resist pattern are removed by using a liquid that contains water.

12. The method according to any of claims 1 to 9, wherein the liquid resist contains a polymer compound that is soluble in an organic solvent, and, in the (c) removing, the resist pattern and the at least one electrode layer formed on the resist pattern are removed by using the organic solvent.

13. The method according to any of claims 1 to 9, wherein the liquid resist contains an inorganic compound powder, a resin and an organic solvent.

14. An apparatus for manufacturing a solar cell comprising a substrate, and an electrode layer disposed on the substrate, the apparatus comprising:
a resist pattern forming system for applying a liquid resist on the substrate so as to form a striped resist pattern.

15. The apparatus according to claim 14, further comprising
an electrode layer forming system for forming the electrode layer so as to cover the resist pattern, and
a removing system for removing the resist pattern and the electrode layer formed on the resist pattern.

16. The apparatus according to claim 15, wherein the substrate is flexible, and
the apparatus further comprises
a first roller, around which the substrate is wound, for supplying the substrate to the resist pattern forming system, and
a second roller for taking up the substrate on which the resist pattern has been formed.

17. The apparatus according to any of claims 14 to 16, wherein the resist pattern forming system comprises an orifice-like nozzle for applying the liquid resist.

18. The apparatus according to claim 17, wherein the resist pattern forming system further comprises a member for charging the liquid resist, and
the nozzle comprises a member for expelling the charged liquid resist by an electrostatic force.

19. The apparatus according to any of claims 14 to 16, wherein the resist pattern forming system comprises
a first roller comprising a printing plate for disposing the liquid resist in a striped manner,
a second roller for pressing the substrate against the first roller, and
a liquid resist supplying system for supplying the liquid resist to the printing plate.

20. The apparatus according to any of claims 14 to 16, wherein the resist pattern forming system comprises a discharge portion with a nozzle for discharging the liquid resist and a supporting portion for supporting the discharge portion, and
the supporting portion is capable of changing an angle that a central axis of the nozzle forms with the substrate.

21. A solar cell comprising:
a substrate having an insulating surface; and
a plurality of unit cells that are formed on the surface and connected in series;
wherein the solar cell comprises a first electrode layer, a semiconductor layer and a second electrode layer that are layered sequentially from a side of the substrate,
the first electrode layer is divided by a striped groove, and
the surface of the substrate is flat in a portion of the groove.
